# DEMANDE DE BREVET EUROPEEN

(11) **EP 1 271 629 A2**
(43) Date de publication de la demande: **02.01.2003**
(21) Numéro de dépôt: 02291499.8
(22) Date de dépôt: 14.06.2002
(51) Int. Cl.: H01L 21/266, H01L 21/033

(54) **Procédé de traitement de zones complémentaires de la surface d'un substrat et produit semi-conducteur obtenu par ce procédé**

(30) Priorité: 21.06.2001 FR 0108192
(71) Demandeur: STMicroelectronics S.A., 92120 Montrouge (FR)
(72) Inventeur: Ferreira, Paul, 38570 Goncelin (FR); Coronel, Philippe, 38530 Barraux (FR)
(74) Mandataire: Verdure, Stéphane

(57) **Abrégé**

L'invention concerne un procédé de traitement d'une portion de la surface (2) d'un substrat selon un premier et un deuxième traitements de surface différents l'un de l'autre et destinés respectivement à un premier groupe de zones (3a) et à un deuxième groupe de zones (3b) de ladite portion de surface (2), ces deux groupes de zones étant complémentaires l'un de l'autre par rapport à ladite portion, le procédé permettant de ne mettre en oeuvre qu'une seule opération de positionnement d'un masque qui différencie les zones des premier et deuxième groupes de zones, en utilisant les mêmes matériaux de protection pour les zones de chaque groupe de zones contre les effets du traitement destiné aux zones de l'autre groupe de zones. Application à l'obtention de produits semi-conducteurs.

## Description

La présente invention concerne un procédé de traitement de zones complémentaires de la surface d'un substrat et un produit semi-conducteur ainsi obtenu par ce procédé.

Elle se rapporte au domaine de l'élaboration de produits semi-conducteurs, et trouve des applications en particulier dans le traitement de substrats par des étapes de traitement différentes sur des zones complémentaires de leur surface.

On désigne par substrat un support ayant éventuellement déjà reçu divers traitements de natures variées, et destiné à recevoir au moins un traitement supplémentaire. La surface de ce support est en général plane ou sensiblement plane pour pouvoir utiliser les outils et méthodes de traitement usuelles des surfaces planes dans le domaine de la fabrication de produits semi-conducteurs, éventuellement adaptés dans le cas de surfaces non rigoureusement planes, par exemple avec des dispositifs de déroulement de la surface cylindrique.

On désigne par produit semi-conducteur un substrat destiné à supporter dans son application finale des composants électroniques. Il s'agit donc en général d'un produit semi-fini apparaissant au cours de l'élaboration d'un ensemble de composants portés par un seul support.

Les traitements de surface considérés par l'invention peuvent être de natures très variées, par exemple l'implantation d'espèces atomiques ou ioniques, le dépôt d'espèces chimiques, la gravure, le traitement de la surface selon un principe physique, notamment par bombardement ou irradiation, le traitement de la surface selon un principe chimique, notamment par réaction de surface, par sensibilisation, etc. La caractéristique des traitements de surface concernés par l'invention est de nécessiter un accès direct à la zone de la surface à traiter, pouvant être un accès par exposition de cette zone découverte, un accès par contact, notamment pour la mise en contact avec une solution liquide, etc. Un traitement de surface particulièrement répandu est l'implantation dans un substrat de silicium d'arsenic ou de phosphore pour lui conférer un comportement semi-conducteur de type n, ou l'implantation de bore ou de fluorure de bore pour lui conférer un comportement semi-conducteur de type p. Plus généralement, les deux traitements de surface des zones du premier groupe de zones et du deuxième groupe de zones sont respectivement deux traitements du substrat par implantation d'espèces atomiques ou ioniques afin de créer deux dopages différents.

Dans le domaine technique ci-dessus, en effet, il est fréquent de devoir appliquer des traitements différents à des zones complémentaires de la surface d'un substrat. Cela se produit lorsqu'un premier groupe de zones doit recevoir un premier traitement de surface, alors qu'un deuxième groupe de zones doit recevoir un deuxième traitement de surface, sans que les zones de chaque groupe de zones soient soumises aux effets du traitement de surface destiné aux zones de l'autre groupe de zones.

On entend par groupes de zones complémentaires par rapport à la portion de surface du substrat la partition de cette portion de surface en deux groupes de zones de façon à ce que la réunion des zones de ces deux groupes de zones reconstitue la portion de surface initiale du substrat dans son intégralité et sans recouvrement de parties de zones.

L'exposition sélective des zones d'un groupe de zones à un traitement de surface qui lui est destiné sans que les zones de l'autre groupe de zones ne soient soumises aux effets de ce traitement de surface nécessite de disposer sur ces dernières zones une ou plusieurs couches d'écran capables de bloquer les effets du traitement sur la surface du substrat ainsi protégée. Les deux groupes de zones devant recevoir un traitement de surface respectif et de façon exclusive par rapport aux zones de l'autre groupe de zones, deux étapes de dépôt de couches d'écran sont nécessaires, successivement sur les zones de chacun des deux groupes de zones avant d'appliquer le traitement de surface destiné à ce groupe de zones.

Ces couches d'écran doivent donc laisser découvertes les zones devant recevoir les effets du traitement de surface qui leur est destiné. Leurs dépôts doivent donc être sélectifs, cette sélectivité résultant de l'utilisation de masques spécifiques respectifs, différenciant les zones de l'un des deux groupes de zones par rapport à celles de l'autre groupe de zones. Chaque masque est positionné par rapport au substrat avec une précision d'environ 0,10 à 0,18 µm, en utilisant des repères d'alignement du masque par rapport au substrat, et avec une procédure en plusieurs étapes récurrentes de réajustement progressif du positionnement du masque. Selon les méthodes existantes, ces opérations de positionnement du masque sont effectuées lors de chaque dépôt de couches d'écran, c'est à dire au moins deux fois dans le cas considéré ici de deux traitements de surface différents appliqués à deux groupes de zones complémentaires de la surface du substrat.

Or, l'imprécision de positionnement des masques précités empêche que les zones d'un groupe de zones soient contiguës à des zones de l'autre groupe de zones, c'est à dire qu'il existe une bande résiduelle de substrat entre les zones de chaque groupe de zones qui soit n'est soumise ni au premier ni au second traitement, soit est successivement soumise aux effets des deux traitements de surface. Ceci se traduit, dans le premier cas, par la formation de parties de la surface dudit substrat non traitées et donc perdues du point de vue de l'élaboration de circuits électroniques. En outre, une bande de substrat qui n'est traitée par aucun des deux traitements de surface possède un état électrique incontrôlé pouvant affecter le fonctionnement ultérieur des circuits électroniques. Ceci est particulièrement le cas pour un substrat de silicium pur quand les deux traitements de surface consistent en des implantations d'espèces dopantes définissant le comportement électrique des zones implantées. Cela se traduit, dans le second cas, par la formation, entre des zones appartenant à des groupes de zones différents de bandes de substrat recevant successivement les deux traitements de surface. De telles zones sont également néfastes, pour les mêmes raisons que ci-dessus exposées, et ceci, en particulier dans le cas précité de traitements de dopage d'un substrat de silicium pur.

C'est pourquoi, un objet de la présente invention est de proposer un procédé ne comprenant l'utilisation que d'un seul masque pour effectuer deux traitements de surface différents destinés à des zones distinctes, et donc ne comprenant qu'une seule opération de positionnement de masque par rapport au substrat.

L'invention concerne plus précisément un procédé de traitement d'une portion de surface d'un substrat comprenant un premier groupe de zones destinées à recevoir un premier traitement de surface et un deuxième groupe de zones destinées à recevoir un deuxième traitement de surface différent du premier traitement de surface, les deux groupes de zones comprenant chacun au moins une zone et étant complémentaires l'un de l'autre par rapport à la portion de surface, suivant lequel :
(a) on réalise une protection sélective des zones du deuxième groupe de zones contre les effets du premier traitement de surface, qui est obtenue par le dépôt sélectif d'au moins une couche formée à partir de premiers matériaux sur lesdites zones, en utilisant un masque qui différencie les zones appartenant au premier groupe de zones des zones appartenant au deuxième groupe de zones ;
(b) on applique le premier traitement de surface de manière qu'il n'a d'effet que sur les zones du premier groupe de zones ;
(c) on réalise une protection sélective des zones du premier groupe de zones contre les effets du deuxième traitement de surface, qui est obtenue par le dépôt sur la portion de surface d'au moins une couche formée à partir de seconds matériaux, et par un retrait sélectif des couches de protection des zones du deuxième groupe de zones contre les effets du premier traitement de surface de manière que des couches de protection ne restent que sur les zones du premier groupe de zones, cette sélectivité étant obtenue en alternant les étapes de retrait de ces couches avec les étapes de dépôt des matériaux à l'origine de la protection des zones du premier groupe de zones contre les effets du deuxième traitement de surface ;
(d) on applique le deuxième traitement de surface de manière qu'il n'a d'effet que sur les zones du second groupe de zones.

Le fait de n'utiliser qu'un seul masque pour avantage de réduire le nombre d'étapes du procédé global, de réduire aussi le nombre d'équipements nécessaires pour ce procédé, le temps de cycle, et donc le coût global de ce procédé.

Ce procédé peut être poursuivi selon la même logique, sur la base de la différenciation initiale entre les deux groupes de zones, c'est à dire sans réutilisation du masque de différenciation des zones des deux groupes de zones, dans le but d'appliquer un troisième traitement de surface sur les zones du premier groupe de zone, et contre les effets duquel les mêmes matériaux de protection que ceux déjà utilisés constituent une protection efficace du substrat. Ainsi, une protection des zones du deuxième groupe de zones peut être reconstruite à partir de couches de protection, tout en retirant les couches de protection des zones du premier groupe de zones par les mêmes étapes de retrait alternées avec les étapes de dépôt des matériaux de protection sur les zones du deuxième groupe de zones. Le troisième traitement de surface peut alors être appliqué de façon à ce qu'il ait effet sur les zones du premier groupe de zones. Cette séquence d'étapes peut encore être répétée sans limitation pour réaliser des traitements de surface ayant effet alternativement sur les zones de chacun des deux groupes de zones sans avoir d'effet sur les zones de l'autre groupe de zones, aucune perte de définition des deux groupes de zones ne se produisant durant cette séquence.

Selon le procédé de l'invention, la protection sélective des zones de chaque groupe de zones respectif contre les effets du traitement de surface destiné aux zones de l'autre groupe de zones est obtenue par au moins une couche d'écran et une couche de protection d'écran. Ces couches sont obtenues à partir de matériaux respectifs déposés séparément sur la portion de surface du substrat. Dans la suite du procédé, la couche d'écran forme pour la zone située en dessous un écran contre les effets du traitement destiné aux zones de l'autre groupe de zones, et la couche de protection d'écran forme une protection de la couche d'écran située en dessous contre un procédé de retrait de la couche d'écran.

Avantageusement la couche de protection d'écran utilisée est en outre photosensible et susceptible de développement. Elle est alors insolée en début du procédé après le dépôt des matériaux à l'origine de la protection des zones du second groupe de zones contre les effets du premier traitement de surface, cette insolation étant réalisée en utilisant le masque qui différencie les zones du premier groupe de zones des zones du deuxième groupe de zones. Selon l'invention, les dépôts ultérieurs de couches de protection d'écran n'utilisent plus d'étapes d'insolation et de développement pour réaliser la protection sélective des zones d'un groupe de zones, mais cette sélectivité est obtenue à partir des couches de protection déjà présentes sur les zones de l'autre groupe de zones.

Pour cela, à l'issue de l'application du premier traitement de surface, le dépôt des nouvelles couches d'écran et de protection d'écran est réalisé lors d'étapes successives alternées avec des étapes de retrait sélectif des couches de protection des zones du deuxième groupe de zones contre les effets du premier traitement de surface.

Ce retrait sélectif des couches de protection des zones du deuxième groupe de zones contre les effets du premier traitement de surface comprend au moins une étape d'abrasion mécanique, ou de gravure sèche, ou de gravure planarisante, ou de dissolution, ou d'attaque chimique.

Ce retrait sélectif est contrôlé dans son avancement progressif en direction de la surface du substrat par rapport au retrait de la couche de protection d'écran présente au-dessus des zones de ce deuxième groupe de zones. Plusieurs méthodes sont possibles pour ce contrôle, notamment l'analyse des résidus de matière retirés peut fournir comme repère un changement de composition chimique de ces résidus par passage d'une couche de matériau d'écran en fin de retrait à une couche de protection d'écran commençant à être retirée, ou bien l'inverse.

Selon une autre méthode de contrôle de l'avancement des étapes de retrait, les couches de protection d'écran possèdent un premier ou un second état distinct, le second état conférant à ladite couche de protection d'écran une propriété de plus grande résistance au procédé de retrait des couches de protection par rapport à la résistance des couches d'écran audit procédé de retrait. L'avancement du retrait des couches successives peut être alors suivi par chronométrage, ou bien, dans le cas d'un retrait par abrasion à l'aide d'un disque rotatif, par suivi du couple de rotation de ce disque, ce couple étant supérieur lorsque l'abrasion concerne la couche de protection d'écran.

Pour cela, les couches de protection d'écran passent de leur premier état à leur second état par un traitement appliqué in-situ. Ce traitement ayant pour effet de «durcir» le matériau de cette couche de protection d'écran, il est préférentiellement effectué après le retrait du ou des matériaux qui constituent cette couche de protection d'écran des zones devant recevoir les effets du traitement de surface suivant.

Selon un mode particulier de mise en oeuvre du procédé de l'invention, l'étape c du procédé comprend les étapes suivantes :
(c1) on réalise, sur au moins les zones du premier groupe de zones, une couche d'écran contre les effets du deuxième traitement de surface ;
(c2) on pratique un retrait partiel de la couche d'écran contre les effets du deuxième traitement de surface de façon à ce que la surface de la couche d'écran contre les effets du deuxième traitement de surface au niveau des zones du premier groupe de zones soit amenée à une altitude inférieure, par rapport à la surface du substrat, à l'altitude, par rapport à la surface du substrat, de l'interface entre la couche d'écran contre les effets du premier traitement de surface et la couche de protection d'écran présentes au niveau des zones du second groupe de zones ;
(c3) on réalise, sur au moins les zones du premier groupe de zones, une couche de protection d'écran ;
(c4) on pratique un retrait partiel des couches de protection d'écran de façon à dévoiler, au niveau des zones du deuxième groupe de zones, la couche d'écran contre les effets du premier traitement de surface ;
(c5) on retire, au niveau des zones du deuxième groupe de zones, la couche d'écran contre les effets du premier traitement de surface.

L'invention concerne aussi un procédé d'obtention d'un produit semi-conducteur comprenant des étapes d'exécution d'un procédé de traitement d'un substrat telles que décrites précédemment.

Elle concerne par ailleurs le produit semi-conducteur traité ou obtenu selon le procédé de l'invention ou ce procédé d'obtention. Un tel produit présente donc des zones contiguës ayant subi des traitements respectifs différents propres à chaque groupe de zones. Dans le cas de traitements d'implantation, la contiguïté des zones ainsi traitées peut être mise en évidence par analyse élémentaire, et dans le cas d'autres traitements, cette contiguïté peut être notamment observée par microscopie électronique à balayage. La constitution de caissons de dopages opposés, p et n, dans des zones contiguës et alternées intervient notamment pour la fabrication de mémoires à transistors nécessitant un grand nombre de transistors réalisés sur un même support avec une densité maximale. D'autres composants électroniques, tels que des processeurs, sont aussi concernés pour leur fabrication par les avantages de la présente invention, notamment afin d'accroître la précision d'élaboration et la miniaturisation des circuits qui les constituent.

D'autres particularités et avantages de la présente invention apparaîtront dans la description ci-après d'un exemple de mise en oeuvre non limitatif, en référence aux dessins annexés, dans lesquels :
- la figure 1 est un exemple de partition d'une portion de surface d'un substrat en deux groupes de zones 3a et 3b contiguës et complémentaires par rapport à ladite portion de surface ;
- les figures 2 à 10 sont des vues en coupe d'un substrat traité selon le procédé de l'invention, suivant des étapes successives respectives du procédé ;
- la figure 11 est un diagramme illustrant les étapes du procédé selon l'invention.

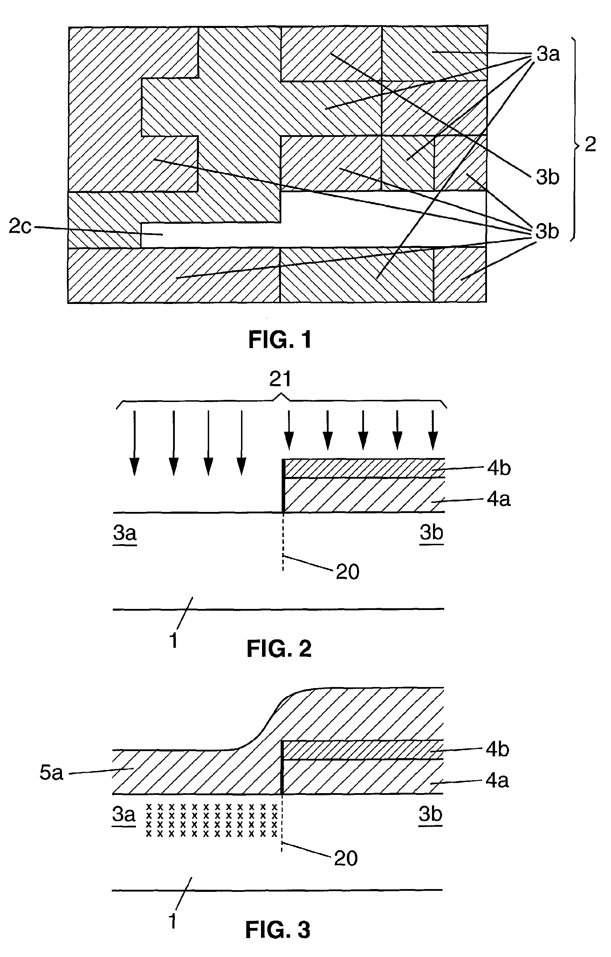

La figure 1 représente une vue de dessus d'un substrat 1 divisé localement entre deux groupes de zones respectivement 3a et 3b. Les zones 3a sont hachurées dans un sens afin de les distinguer des zones 3b hachurées dans l'autre sens. La portion de surface 2 du substrat regroupe les zones 3a et 3b. Ces zones sont destinées à recevoir un premier ou un second traitement de surface selon le procédé de la présente invention. La portion de surface 2 peut ne pas représenter toute la surface du substrat 1, si bien qu'une portion de surface 2c, complémentaire de la portion de surface 2 par rapport à l'intégralité de la surface du substrat 1, ne doit recevoir aucun des deux traitements de surface envisagés. Un masque dur de protection est alors initialement déposé sur cette portion de surface 2c, afin de la protéger des effets de tous les traitements appliqués dans la suite. La portion de surface 2c ainsi protégée est alors indifféremment intégrée dans le groupe de zones 3a ou dans le groupe de zones 3b, si bien que les zones 3a et 3b apparaissent alors complémentaires par rapport à l'intégralité de la surface du substrat 1. A la fin du procédé selon la présente invention, le masque dur est retiré de la portion de surface 2c qui est alors restituée dans son état initial.

A la figure 2, la partition, entre deux zones 3a et 3b adjacentes est représentée par une ligne verticale en traits discontinus 20. Les zones 3b sont recouvertes d'une couche d'écran 4a et d'une couche de protection d'écran 4b. La couche d'écran a par exemple une épaisseur approximative de 1,5 µm, et la couche de protection d'écran une épaisseur approximative de 0,3 µm.

Notamment, dans le cas décrit ci-après de la réalisation de transistors à la surface d'un substrat de silicium, ce substrat, selon les méthodes connues de l'homme du métier, peut déjà avoir reçu plusieurs étapes de traitement destinées à disposer à sa surface des zones localisées d'isolation électrique d'environ 0,5 µm de profondeur sous la surface de ce substrat et de dimensions parallèles à cette surface de l'ordre de 0,3 µm, ainsi que pour constituer une couche d'oxyde de faible épaisseur sur toute la portion de la surface du substrat destinée à recevoir la réalisation des transistors. Par simplification, ces zones localisées et cette couche d'oxyde ne sont pas représentées aux figures.

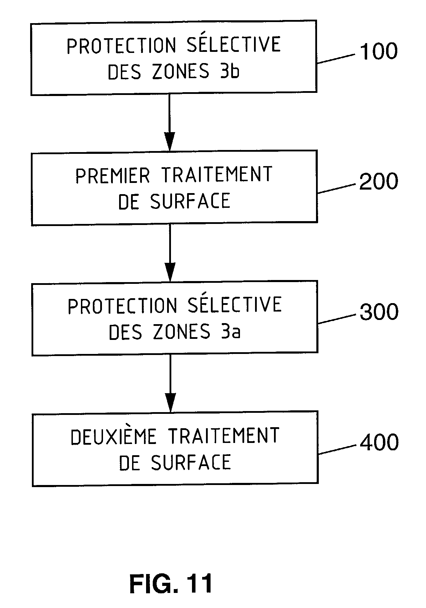

Les étapes du procédé selon l'invention sont illustrées par le diagramme de la figure 11.

Dans une première étape 100, on réalise une protection sélective des zones 3b du deuxième groupe de zones contre les effets du premier traitement de surface.

Cette protection est obtenue par le dépôt sélectif sur les zones du second groupe de zones des matériaux à l'origine des couches d'écran 4a et de protection d'écran 4b est effectué de façon usuelle pour l'homme du métier.

La couche d'écran est tout d'abord réalisée par dépôt sur l'ensemble de la portion de surface 2 de matériaux capables de réaliser la protection des zones recouvertes contre les effets du premier traitement de surface. Ce dépôt peut être effectué sur substrat mis en rotation («spin coating») recevant en son centre une solution liquide précurseur du matériau, ou par immersion du substrat («dip coating») dans une solution de même type, ou encore par enduction du substrat par des réactifs sous forme visqueuse ou poudreuse suivie d'un raclage pour le contrôle de l'épaisseur déposée. Le dépôt comprend ensuite une étape de recuisson du matériau ainsi déposé pour solidifier la couche d'écran 4a et amener éventuellement le matériau dont elle est constituée dans l'état chimique final procurant la fonction recherchée d'écran lors de l'application du premier traitement de surface. La couche de protection d'écran 4b est réalisée alors de façon analogue, en appliquant sur la couche d'écran les matériaux correspondant à sa composition, puis en effectuant un éventuel second recuit afin de la solidifier à son tour.

Les matériaux des couches d'écran et de protection d'écran sont alors sélectivement retirés des zones 3a du premier groupe de zones devant être soumises au premier traitement de surface. Ce retrait sélectif est effectué par une méthode usuelle mettant en oeuvre un photoresist. Selon cette méthode, le photoresist est tout d'abord déposé sur la couche de protection d'écran. Suivent alors des étapes d'irradiation de ce photoresist au travers d'un masque correctement positionné, de développement du photoresist et de retrait de ce photoresist, soit dans les zones exposées à l'irradiation au travers du masque, soit dans les zones occultées par le masque lors de l'irradiation selon que le photoresist est à développement positif ou négatif. On procède enfin au retrait des couches d'écran et de protection d'écran des zones où elles ne sont pas protégées par le photoresist, de façon à ce qu'il ne reste de couches d'écran et de protection d'écran, elles-mêmes recouvertes de photoresist, que dans les zones 3b du deuxième groupe de zones.

L'étape de positionnement d'un masque différenciant les zones 3a du premier groupe de zones des zones 3b du deuxième groupe de zones intervient par conséquent lors du dépôt des matériaux à l'origine de la protection sélective des zones du deuxième groupe de zones. Selon la présente invention, elle est l'unique étape utilisant un masque devant être positionné sur le substrat, toutes les étapes ultérieures traitant différemment les zones des deux groupes de zones résultant de cette différenciation entre les deux groupes de zones 3a et 3b initialement faite à l'aide de ce masque.

L'irradiation du photoresist est effectuée d'une façon adaptée à la nature du photoresist utilisé, Elle peut être une irradiation par lumière ultraviolette d'intensité suffisante et de longueur d'onde convenable compte tenu de la sensibilité du photoresist, ou un bombardement par des électrons envoyés sur la surface du photoresist sous forme d'un faisceau balayant cette surface. La méthode de développement du photoresist après irradiation dépend aussi de la nature du photoresist utilisé : un développement par dissolution dans une solution liquide spécifique est notamment couramment utilisé.

Le procédé EIRIS™, dont les composants sont commercialisés par la Société JSR (11-24 Tsukiji 2-Chome, Cho-Ku, Tokyo, 104 JAPAN), comprend la fourniture des matériaux à l'origine de la couche d'écran et de la couche de protection d'écran à déposer sur le substrat, ainsi que les caractéristiques des traitements de recuisson de chacune de ces couches. Ce procédé EIRIS™ est cité à des fins d'illustration de la présente invention, sans limitation aucune par rapport à d'autres procédés mettant en oeuvre au moins deux couches de résines dont l'une est riche en silicium, et comportant les mêmes fonctionnalités que le procédé EIRIS™. Selon la notice de mise en oeuvre du procédé EIRIS™, la couche d'écran doit notamment être recuite à 170°C pendant 120 s et la couche de protection d'écran à 120°C pendant 60 s. Dans le cas particulier du procédé EIRIS™, la couche de protection d'écran remplit aussi la fonction de photoresist, qui est sensible à une irradiation à la longueur d'onde de 365 nm («MID'UV»), ou à la longueur d'onde plus énergétique de 248 nm («deep UV»). Un deuxième recuit de la couche de protection d'écran est alors nécessaire, nommé «post exposure bake» dans la notice précitée, puis elle est développée en positif, c'est-à-dire que ne reste, après développement, une couche de protection d'écran qu'aux endroits où elle a été insolée. Dans le cadre de l'utilisation du procédé EIRIS™, le masque différenciant les deux groupes de zones doit donc occulter les zones du premier groupe de zones vis-à-vis de la lumière d'insolation.

La couche de protection d'écran ainsi élaborée se trouve dans son premier état. Elle est alors transformée par un traitement par plasma d'oxygène sous pression réduite auquel est soumis l'intégralité de la surface du substrat 1. Ce traitement amène la couche de protection d'écran dans son second état, plus résistant aux procédés de retrait grâce à la formation en son sein de silice SiO₂ durant ce traitement par plasma oxydant.

Le retrait sélectif de la couche d'écran des zones du premier groupe de zones est réalisé simultanément par le traitement par plasma d'oxygène précédent. En raison de la nature organique de cette couche d'écran, de type résine, le plasma d'oxygène en permet la gravure en même temps qu'il transforme la couche de protection d'écran en matériau contenant de la silice. Grâce à sa résistance spécifique contre ce procédé de retrait, due à la formation de silice, la couche de protection d'écran joue le rôle de protection de la couche d'écran au niveau des zones du second groupe de zones lors de cette étape de retrait.

A l'issue de cette première étape 100, les zones 3a de la portion de surface 2 du substrat du premier groupe de zones sont découvertes, alors que les zones 3b du second groupe de zones sont protégées par la couche d'écran 4a recouverte par la couche de protection d'écran 4b, selon la représentation de la figure 2.

Le procédé est alors poursuivi, dans une étape 200, par l'application du premier traitement de surface sur toute la portion de surface 2 du substrat, à savoir par exemple, une implantation ionique 21 sous la surface de ce substrat de façon à lui conférer localement un comportement semi-conducteur de type n. Il n'a alors d'effet sur le substrat qu'au niveau des zones 3a du premier groupe de zones, celles 3b du deuxième groupe de zones étant protégées contre les effets de ce traitement de surface par la couche d'écran 4a appliquée précédemment.

Dans une étape 300, on réalise alors une protection des zones 3a du premier groupe de zones contre les effets du deuxième traitement de surface. Dans l'exemple particulier considéré ici à fin d'illustration, les matériaux du procédé EIRIS™ sont utilisés une seconde fois pour effectuer la protection des zones 3a. On suppose donc que ces matériaux sont capables de procurer une protection efficace contre les effets du second traitement de surface, en plus de leur efficacité de protection contre les effets du premier traitement de surface. Ceci est une situation particulière, mais en général les couches d'écran 4a et 5a de protection des zones 3a et 3b de chaque groupe doivent être différentes, adaptées à chaque traitement de surface concernant chacun des deux groupes de zones. On procède par conséquent à une seconde application des matériaux à l'origine de la couche d'écran sur l'ensemble de la portion de surface 2 du substrat par une méthode analogue à celle utilisée à l'étape 100. On obtient ainsi la configuration représentée à la figure 3. Une couche d'écran 5a, d'épaisseur approximativement égale à 1,8 - 2,0 µm, est directement en contact avec la surface du substrat 1 au niveau des zones 3a du premier groupe de zone, et recouvre la couche de protection d'écran 4b au niveau des zones 3b du second groupe de zones.

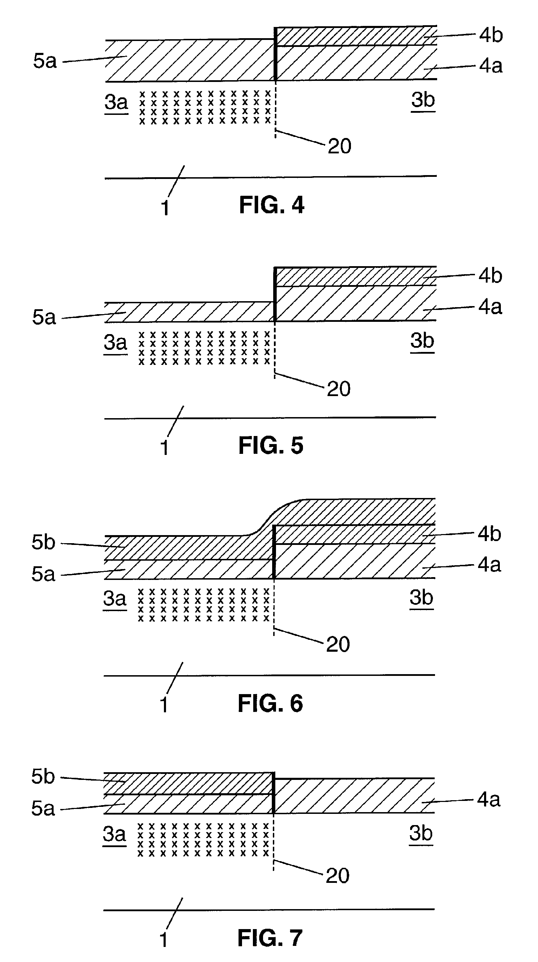

Un retrait partiel de cette seconde couche d'écran est alors pratiqué, par exemple par abrasion mécanique, de façon à retirer complètement cette nouvelle couche d'écran des zones du second groupe de zones. On obtient alors la configuration représentée à la figure 4.

A cause de la différence de hauteur de la couche d'écran 5a par rapport à la surface du substrat entre les zones 3a et 3b de chaque groupe de zones, cette couche d'écran 5a est complètement retirée au niveau des zones 3b du second groupe de zones alors qu'il en reste une épaisseur de l'ordre de 1,7 µm au niveau des zones 3a du premier groupe de zones. Précisément, la surface de la couche d'écran 5a au niveau des zones 3a du premier groupe de zones est un peu en dessous de la surface de la couche de protection d'écran 4b au niveau des zones 3b du second groupe de zones. Ceci provient de la moindre résistance de la couche 5a à l'abrasion pratiquée par rapport à la couche 4b.

Cette abrasion mécanique par rotation est arrêtée et repérée lorsque le couple de rotation appliqué nécessaire pour maintenir une vitesse de rotation constante sous la même pression d'abrasion subit un accroissement, dû à la plus grande résistance au frottement de la couche de protection d'écran 4b au niveau des zones 3b du second groupe de zones lorsque celle-ci est dévoilée au cours de l'abrasion. La propriété de plus grande résistance au frottement et à l'abrasion, qui se situe dans un rapport de 1 à 10, que présente la couche de protection d'écran 4b par rapport à la couche d'écran 5a provient du traitement par plasma oxydant effectué à l'étape 100 après son retrait des zones 3a du premier groupe de zones.

Toute autre technique de détection de fin d'élimination de la seconde couche d'écran 5a au niveau des zones 3b peut être alternativement utilisée. Par exemple, la détection d'une certaine proportion d'élément silicium révélée par une analyse des résidus de polissage indique que le niveau d'abrasion a atteint la couche de protection d'écran 4b au niveau des zones 3b.

L'abrasion mécanique est en général légèrement poursuivie («overpolishing») de façon à accroître, grâce à la différence de vitesse d'abrasion, la différence de hauteur entre la surface supérieure de la couche d'écran 5b au niveau des zones 3a du premier groupe de zones et la surface supérieure, située plus haut, de la couche de protection d'écran 4b au niveau des zones 3b du second groupe de zones. On obtient alors la configuration de la figure 5, selon laquelle la surface de la couche d'écran 5a au niveau des zones 3a du premier groupe de zones est amenée à une altitude inférieure à celle de l'interface entre la couche d'écran 4a et la couche de protection d'écran 4b présentes au-dessus des zones 3b du second groupe de zones.

Les matériaux à l'origine de la couche de protection d'écran sont alors de nouveau déposés en une couche 5b présente sur toute la portion de surface du substrat à traiter selon une procédure analogue à celle déjà utilisée à l'étape 100, afin d'aboutir à une configuration de cette surface conforme à la figure 6.

Une abrasion mécanique est alors de nouveau pratiquée sur toute la portion de surface 2 du substrat à traiter de façon à retirer intégralement les matériaux de protection d'écran 5b des zones 3b du second groupe de zones. Cette abrasion est arrêtée lors qu'elle dévoile au niveau de ces zones 3b la couche d'écran 4a. On obtient alors la configuration selon la figure 7. Comme la surface supérieure de la couche d'écran 5a au niveau des zones 3a du premier groupe de zones avait été rabaissée lors de la première étape d'abrasion mécanique en dessous du niveau de la surface inférieure de la couche de protection d'écran 4b à l'endroit des zones 3b du second groupe de zones, il reste alors une épaisseur significative de matériaux de protection d'écran 5b au-dessus de la couche d'écran 5a au niveau des zones 3a du premier groupe de zones.

Par un traitement par plasma oxydant à pression réduite identique à celui déjà effectué, la couche de protection d'écran 5b présente sur les zones 3a du premier groupe de zones est alors amenée dans son second état lui conférant une résistance accrue à l'abrasion.

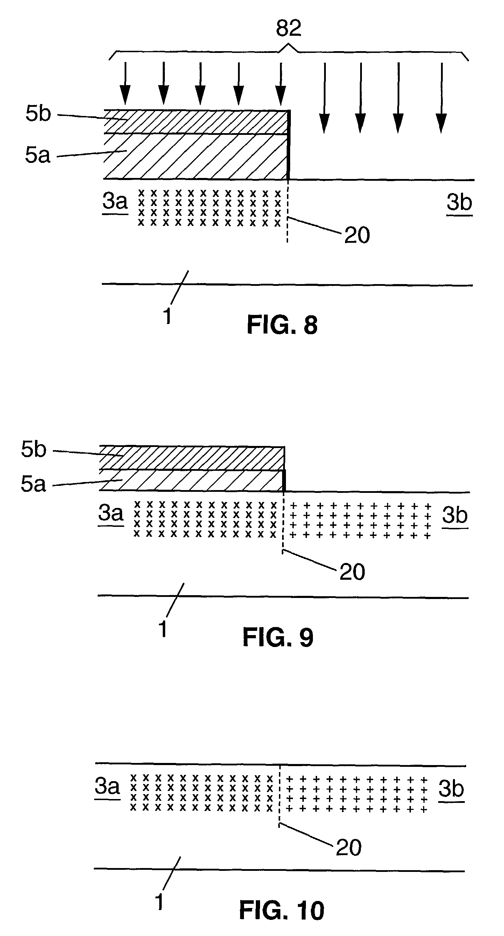

Simultanément, la couche d'écran 4a présente sur les zones 3b du second groupe de zones est retirée par ce traitement par plasma oxydant. A l'issue de cette étape, les zones 3b de la portion de surface du substrat du second groupe de zones sont découvertes, alors que les zones 3a du premier groupe de zones sont protégées par la couche d'écran 5a recouverte par la couche de protection d'écran 5b, selon la configuration de la figure 8.

Dans une étape 400, le second traitement de surface est alors appliqué sur toute la portion de surface 2 du substrat, à savoir par exemple une implantation ionique 82 sous la surface de ce substrat de façon à lui conférer localement un comportement semi-conducteur de type p. Il n'a alors d'effet sur le substrat, comme montré à la figure 9, qu'au niveau des zones 3b du second groupe de zones, les zones 3a du premier groupe de zones étant protégées contre les effets de ce traitement de surface par la couche d'écran 5a appliquée précédemment.

Le procédé peut être alors poursuivi de façon itérative en traitant alternativement les zones des premier et second groupes de zones, tout en protégeant pour chaque traitement les zones de l'autre groupe de zones.

En fin de procédé, ou à l'issue du second traitement de surface, une abrasion mécanique permet de retirer la couche de protection d'écran 5b présente au-dessus des zones 3a du premier groupe de zones, et est poursuivie jusqu'à ce qu'elle dévoile la couche d'écran 5a présente sur ces zones. La couche d'écran 5a est alors retirée à son tour par l'un des procédés de retrait de couches d'écran déjà utilisé : dissolution, attaque chimique, ou gravure sèche par plasma (ou «etching»). La surface du substrat est alors restituée nue, comme illustré par la figure 10, et présente, dans les zones 3a et 3b de la portion de surface 2 des propriétés dépendant de la nature d'implantation ionique du groupe de zones correspondant, à savoir, dans l'exemple, respectivement un dopage n et un dopage p.

## Revendications

1. Procédé de traitement d'une portion de surface (2) d'un substrat (1) comprenant un premier groupe de zones (3a) destinées à recevoir un premier traitement de surface et un deuxième groupe de zones (3b) destinées à recevoir un deuxième traitement de surface différent du premier traitement de surface, les deux groupes de zones (3a, 3b) comprenant chacun au moins une zone et étant complémentaires l'un de l'autre par rapport à la portion de surface (2), procédé suivant lequel on effectue les étapes suivantes :
(a) on réalise (100) une protection sélective des zones (3b) du deuxième groupe de zones contre les effets du premier traitement de surface, qui est obtenue par le dépôt sélectif d'au moins une couche formée à partir de premiers matériaux sur lesdites zones, en utilisant un masque qui différencie les zones appartenant au premier groupe de zones des zones appartenant au deuxième groupe de zones ;
(b) on applique (200) le premier traitement de surface de manière qu'il n'a d'effet que sur les zones (3a) du premier groupe de zones ;
(c) on réalise (300) une protection sélective des zones (3a) du premier groupe de zones contre les effets du deuxième traitement de surface, qui est obtenue par le dépôt sur la portion de surface (2) d'au moins une couche formée à partir de seconds matériaux, et par un retrait sélectif des couches de protection des zones (3b) du deuxième groupe de zones contre les effets du premier traitement de surface de manière que des couches de protection ne restent que sur les zones (3a) du premier groupe de zones, cette sélectivité étant obtenue en alternant les étapes de retrait de ces couches avec les étapes de dépôt des matériaux à l'origine de la protection des zones du premier groupe de zones contre les effets du deuxième traitement de surface ;
(d) on applique (400) le deuxième traitement de surface de manière qu'il n'a d'effet que sur les zones (3b) du second groupe de zones. et suivant lequel la protection sélective des zones de chaque groupe de zones respectif contre les effets du traitement de surface destiné aux zones de l'autre groupe de zones est obtenue par au moins une couche d'écran (4a, 5a) et une couche de protection d'écran (4b, 5b), ces couches étant obtenues à partir de matériaux respectifs qui sont déposés séparément sur la portion de surface du substrat, la couche d'écran formant pour la zone située en dessous un écran contre les effets du traitement destiné aux zones de l'autre groupe de zones, la couche de protection d'écran formant une protection de la couche d'écran située en dessous contre un procédé de retrait de la couche d'écran.

2. Procédé selon la revendication 1, suivant lequel le retrait sélectif des couches de protection des zones (3b) du deuxième groupe de zones comprend au moins une étape d'abrasion mécanique, ou de gravure sèche, ou de gravure planarisante, ou de dissolution, ou d'attaque chimique.

3. Procédé selon la revendication 1 ou la revendication 2, suivant lequel le retrait sélectif des couches de protection des zones (3b) du deuxième groupe de zones est contrôlé par rapport au retrait de la couche de protection d'écran (4b) présente au-dessus des zones de ce deuxième groupe de zones.

4. Procédé selon l'une quelconque des revendications précédentes, suivant lequel l'étape c comprend les étapes suivantes :
(c1) on réalise, sur au moins les zones (3a) du premier groupe de zones, une couche d'écran (5a) contre les effets du deuxième traitement de surface ;
(c2) on pratique un retrait partiel de la couche d'écran (5a) contre les effets du deuxième traitement de surface de façon à ce que la surface de la couche d'écran (5a) contre les effets du deuxième traitement de surface au niveau des zones (3a) du premier groupe de zones soit amenée à une altitude inférieure, par rapport à la surface (2) du substrat (1), à l'altitude, par rapport à la surface (2) du substrat (1), de l'interface entre la couche d'écran (4a) contre les effets du premier traitement de surface et la couche de protection d'écran (4b) présentes au niveau des zones (3b) du second groupe de zones ;
(c3) on réalise, sur au moins les zones (3a) du premier groupe de zones, une couche de protection d'écran (5b) ;
(c4) on pratique un retrait partiel des couches de protection d'écran (4b, 5b) de façon à dévoiler, au niveau des zones (3b) du deuxième groupe de zones, la couche d'écran (4a) contre les effets du premier traitement de surface ;
(c5) on retire, au niveau des zones (3b) du deuxième groupe de zones, la couche d'écran (4a) contre les effets du premier traitement de surface.

5. Procédé selon l'une quelconque des revendications précédentes, suivant lequel les couches de protection d'écran (4b, 5b) présentent un premier ou un second état distinct, le second état conférant à ladite couche de protection d'écran une propriété de plus grande résistance au procédé de retrait des couches de protection par rapport à la résistance des couches d'écran audit procédé de retrait.

6. Procédé selon la revendication 5, suivant lequel les couches de protection d'écran passent de leur premier état à leur second état par un traitement appliqué in-situ.

7. Procédé selon l'une quelconque des revendications précédentes, suivant lequel la couche de protection d'écran étant photosensible et susceptible de développement, elle est insolée après le dépôt des matériaux à l'origine de la protection des zones (3b) du second groupe de zones contre les effets du premier traitement de surface en utilisant le masque qui différencie les zones (3a) du premier groupe de zones des zones (3b) du deuxième groupe de zones.

8. Procédé selon l'une quelconque des revendications précédentes, suivant lequel les premier et second traitements de surface sont des traitements du substrat par implantation d'espèces atomiques ou ioniques permettant de créer des dopages respectifs du substrat qui sont différents l'un de l'autre.

9. Procédé d'obtention d'un produit semi-conducteur comprenant des étapes d'exécution d'un procédé de traitement d'un substrat selon l'une quelconque des revendications 1 à 8.

10. Produit semi-conducteur traité ou obtenu par un procédé selon l'une quelconque des revendications 1 à 8 ou selon un procédé selon la revendication 9 respectivement.
